# EUROPÄISCHE PATENTSCHRIFT

(11) **EP 0 901 222 B1**
(45) Veröffentlichungstag und Bekanntmachung des Hinweises auf die Patenterteilung: **16.02.2005**
(21) Anmeldenummer: 98115514.6
(22) Anmeldetag: 18.08.1998
(51) Int. Cl.: H03G 3/30

(54) **Schwundausgleichsschaltung**
Fading compensation circuit
Circuit de compensation d'évanouissement du signal

(30) Priorität: 02.09.1997 DE 19738359
(43) Veröffentlichungstag der Anmeldung: 10.03.1999
(73) Patentinhaber: Infineon Technologies AG, 81669 München (DE)
(72) Erfinder: Heinen, Stefan, Dr., 47802 Krefeld (DE)
(74) Vertreter: Epping, Hermann, Fischer

(56) Entgegenhaltungen:
- EP-A- 0 569 688
- US-A- 4 675 880
- US-A- 5 469 115
- US-A- 5 617 060

## Beschreibung

Die vorliegende Erfindung betrifft eine Schwundausgleichsschaltung für in der Form von zwei Komponenten I=A^{·}sin(wt) und Q=A^{·}cos(wt) vorliegende Signale. Solche Schwundausgleichsschaltungen finden beispielsweise bei Empfängern für Mobilfunksysteme Verwendung. Dabei wird angestrebt, die Empfänger für Mobilfunksysteme möglichst vollständig zu integrieren. Eine vollständige Integration eines solchen Empfängers für Mobilfunksysteme kann durch Realisierung eines Low-IF oder Zero-IF-Empfängers gelöst werden. Dies bedeutet, daß entweder eine Zwischenfrequenz in der Größenordnung der Modulationsfrequenz (Low-IF) gewählt wird, oder auf eine Zwischenfrequenz ganz verzichtet wird (Zero-IF). Bei Verwendung einer so niedrigen Zwischenfrequenz oder bei vollständigem Verzicht auf die Zwischenfrequenz stellt sich das Problem, daß ein schneller Schwundausgleich (AGC) erforderlich ist, d.h., es muß eine schnelle Regelschleife zur Einstellung der Verstärkung nach der Kanalfilterung zur Verfügung gestellt werden. Dies ist aufgrund der TDMA-Struktur (Mehrfachzugriff im Zeitvielfach) und der Eigenschaften des Funkkanals dringend erforderlich, um eine lineare Verstärkung zu garantieren.

Bei Mobilfunkempfängern gemäß dem Stand der Technik, (beispielsweise dem Analog-Devices-Baustein AD607) muß für die AGC eine Tiefpaßfilterung zur Unterdrückung von Amplitudenschwankungen vorgesehen werden, deren Grenzfrequenz deutlich unterhalb der gewählten Zwischenfrequenz (IF) liegt, da sonst der automatische Schwundausgleich das Nutzsignal beeinträchtigt. Gemäß dem Stand der Technik muß also die Grenzfrequenz dieses Tiefpasses bei Low-IF- und Zero-IF-Schaltungen entsprechend niedrig liegen. Dadurch wird der automatische Schwundausgleich jedoch sehr langsam.

Es ist daher Aufgabe der vorliegenden Erfindung, eine entsprechende Schwundausgleichsschaltung für in der Form von Inphase-(I) und Quadratur-(Q)-Komponente vorliegende Signale zu schaffen, die erheblich schneller arbeitet.

In der Schrift US-A-4 675 880 wird eine Regelung mittels quadrierter und auschließend addierter Quadraturkomponenten beschrieben.

Erfindungsgemäß wird die Aufgabe dadurch gelöst, daß jede der Komponenten (I, Q) einem Verstärker mit exponentiell einstellbarer Verstärkung zugeführt wird, und zur Regelung der Verstärkung die Ausgangssignale der Verstärker jeweils einem Quadrierer zugeführt werden, und die beiden quadrierten Ausgangssignale einem Summierer zugeleitet werden, und die Summe der beiden quadrierten Ausgangssignale einem Integrator oder Tiefpaßfilter zugeführt wird, dessen Ausgangssignal zur Einstellung der Verstärkung der beiden Verstärker dient.

Der Integrator wird als ein bandbegrenzter Integrator vorgesehen, der die Differenz zu einem Sollwert integriert.

Es ist weiter bevorzugt, zwischen dem Integrator und den Verstärkern einen Multiplizierer anzuordnen, der das Ausgangssignal des Integrators mit einer Steuergröße multipliziert.

Die Erfindung wird im folgenden anhand des in der Zeichnung dargestellten Ausführungsbeispiels näher erläutert. Es zeigt:

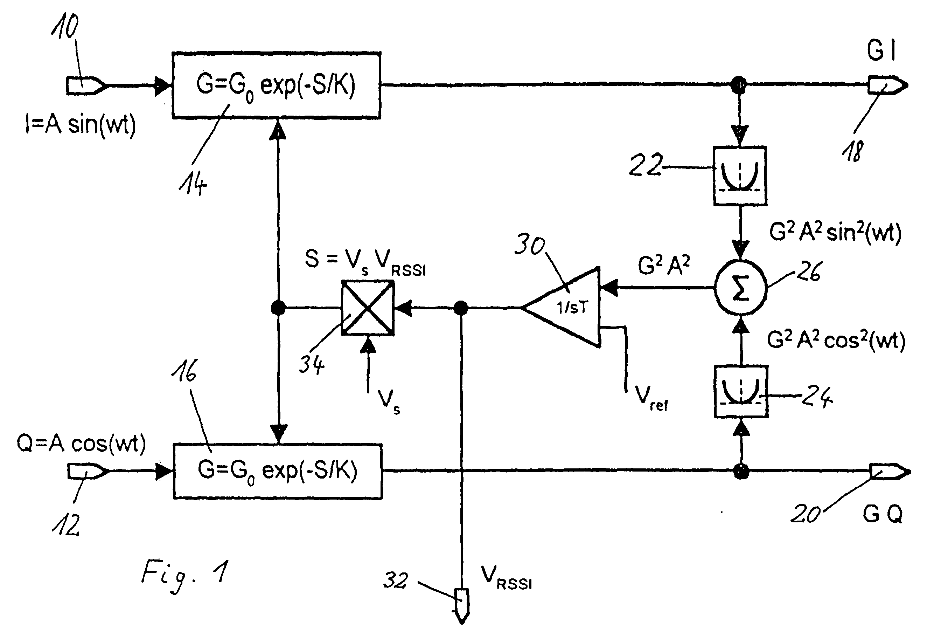

Figur 1 ein Blockschaltbild einer erfindungsgemäßen schnellen Schwundausgleichsschaltung.

Die in Fig. 1 schematisch im Blockschaltbild dargestellte Schwundausgleichsschaltung verfügt über einen Eingang 10 für die Inphasekomponente I = A ^{·} sin(wt) sowie über den Eingang 12 für die Quadraturkomponente Q = A ^{·} cos (wt) .

Von den Eingängen 10, 12 wird sowohl die Inphase- als auch die Quadraturkomponente jeweils einem mehrstufigen Verstärker mit exponentiell einstellbarer Verstärkung zugeführt. Der Verstärker für die Inphasekomponente ist mit 14, der Verstärker für die Quadraturkomponente ist mit 16 bezeichnet. Die Verstärker verfügen über einen Steuereingang, über den den Verstärkern ein Steuersignal S zugeführt werden kann. Durch dieses Steuersignal wird die Verstärkung G des jeweiligen Verstärkers nach der Formel G = G₀ exp(-S/K) eingestellt. Die Ausgänge der Verstärker 14, 16 führen zu den Ausgängen 18, 20 der Verstärkerschaltung. Am Ausgang 18 soll schließlich das Signal G ^{·} I und am Ausgang 20 soll das Signal G ^{·} Q anliegen. Die Regelung der Verstärker 14, 16 zur Erzielung eines automatischen Schwundausgleichs erfolgt nun dadurch, daß sowohl das Ausgangssignal des Verstärkers 14 als auch das Ausgangssignal des Verstärkers 16 jeweils auf einen Quadrierer 22, 24 geführt wird. Der Quadrierer 22 liefert aus dem Signal G ^{·} A ^{·} sin (wt) das Signal G²A² sin²(wt) und der Quadrierer 24 liefert aus dem Signal G ^{·} A ^{·} cos(wt) das Signal G^{2 ·} A^{2 ·} cos² (wt). Die beiden Ausgangssignale der Verstärker 22 und 24 werden einem Summierer 26 zugeführt. In dem Summierer entsteht das Signal G² A² sin²(wt) + G² A² cos² (wt) = G² A² (sin²(wt) + cos²(wt))² = G² A². Dieses Signal wird nun einem bandbegrenzten Integrator 30 zugeführt. Der Integrator integriert die Differenz des Signals G² A² zu einem Sollwert V_{REF}. Es entsteht so das Signal V_{RSSI}. Dieses Signal V_{RSSI} wird einerseits auf einen Ausgang 32 geführt, und andererseits einem Multiplizierer 34 zugeführt. Der Multiplizierer 34 dient als Skallierungsglied und multipliziert das Signal V_{RSSI} mit einer Steuergröße Vₛ. Das dabei entstehende Signal S = Vₛ ^{·} V_{RSSI} wird den Steuereingängen der beiden Verstärker 14, 16 zugeführt, wodurch der Regelkreis geschlossen ist.

Das Signal V_{RSSI} wird über den Ausgang 32 herausgeführt, da dieses Signal proportional der aktuellen Empfangsfeldstärke ist. Bei Mobilfunkempfängern dient dieses Signal beispielsweise auch dazu, festzustellen, wenn sich der Empfänger der Grenze eines Sendebereichs nähert.

Die wesentliche Neuerung der vorliegenden Erfindung gegenüber bekannten Schwundausgleichsschaltungen, beispielsweise aus dem Analog-Devices-Baustein AD607 liegt darin, daß durch die Summation der quadrierten Ausgangssignale der Verstärker 14, 16 aus dem I und Q-Pfad eine konstante Größe (Betragsquadrat) entsteht, die von wt unabhängig ist. Eine Tiefpaßfilterung oder Integration zur Unterdrückung von Amplitudenschwankungen ist zwar auch hier notwendig, die Grenzfrequenz kann jedoch ohne Auswirkung auf die Verstärkung der Schwundausgleichsschaltung (AGC-Verstärkung) oberhalb der gewählten Zwischenfrequenz (IF) liegen. In einer konventionellen Schwundausgleichsschaltung ohne Betragsbildung wäre dies nicht möglich.

## Patentansprüche

1. Schwundausgleichsschaltung für in der Form von zwei Komponenten I = A ^{·} sin(wt) und Q=A ^{·} cos(wt) vorliegende Signale,
**dadurch gekennzeichnet,**
**daß** jede der Komponenten (I, Q) einem Verstärker (14, 16) mit exponentiell einstellbarer Verstärkung zugeführt wird, und zur Regelung der Verstärkung die Ausgangssignale der Verstärker (14, 16) jeweils einem Quadrierer (22, 24) zugeführt werden, und die beiden quadrierten Ausgangssignale einem Summierer (26) zugeleitet werden, und die Summe der beiden quadrierten Ausgangssignale einem Integrator (30) oder Tiefpaßfilter zugeführt wird, dessen Ausgangssignal (V_{RSSI}) zur Einstellung der Verstärkung der beiden Verstärker (14, 16) dient, wobei als Integrator (30) ein bandbegrenzter Integrator vorgesehen ist, der die Differenz zu einem Sollwert (V_{ref}) integriert.

2. Schwundausgleichsschaltung nach Anspruch 1,
**dadurch gekennzeichnet,**
**daß** zwischen dem Integrator (30) und den Verstärkern (14, 16) ein Multiplizierer (34) angeordnet ist, der das Ausgangssignal (V_{RSSI}) des Integrators (30) mit einer Steuergröße (V_{S}) multipliziert.

## Claims

1. Fade compensation circuit for signals which are in the form of two components I = A ^{·} sin(ωt) and Q = A ^{·} cos(ωt),
**characterized**
**in that** each of the components (I, Q) is supplied to an amplifier (14, 16) with an exponentially variable gain, and the output signals from the amplifiers (14, 16) are supplied to a respective squarer (22, 24) in order to control the gain, and the two squared output signals are passed to an adder (26) and the sum of the two squared output signals is supplied to an integrator (30) or low-pass filter, whose output signal (V_{RSSI}) is used to set the gain of the two amplifiers (14, 16), with a band-limited integrator which integrates the difference from a nominal value (V_{ref}) being provided as the integrator (30).

2. Fade compensation circuit according to Claim 1,
**characterized**
**in that** a multiplier (34) is arranged between the integrator (30) and the amplifiers (14, 16) and multiplies the output signal (V_{RSSI}) from the integrator (30) by a control variable (Vₛ).

## Revendications

1. Circuit de compensation d'évanouissement de signaux se présentant sous la forme de deux composantes I = A ^{·} sin (wt) et Q=A ^{·} cos (wt), **caractérisé**
**en ce que** chacune des composantes (I, Q) est envoyée à un amplificateur (14, 16) à amplification réglable exponentiellement et, pour la régulation de l'amplification, les signaux de sortie de l'amplificateur (14, 16) sont envoyés respectivement à un dispositif (22, 24) d'élévation au carré et les deux signaux de sortie élevés au carré sont envoyés à un dispositif (26) de sommation et la somme des deux signaux de sortie élevés au carré est envoyée à un intégrateur (30) ou à un filtre passe-bas, dont le signal (V_{RSSI}) de sortie sert au réglage de l'amplification des deux amplificateurs (14, 16), dans lequel il est prévu, comme intégrateur (30), un intégrateur à limitation de bande, qui intègre la différence en une valeur (Vref) de consigne.

2. Circuit de compensation d'évanouissement suivant la revendication 1,
**caractérisé en ce qu'**
il est monté, entre l'intégrateur (30) et les amplificateurs (14, 16), un multiplicateur (34), qui multiplie le signal (V_{RSSI}) de sortie de l'intégrateur (30) par une grandeur (Vs) de commande.
